# FASCICULE DE BREVET EUROPEEN

(11) **EP 1 870 716 B1**
(45) Date de publication et mention de la délivrance du brevet: **08.05.2013**
(21) Numéro de dépôt: 07110722.1
(22) Date de dépôt: 21.06.2007
(51) Int. Cl.: G01R 21/12

(54) **Dispositif de detection hyperfrequence large bande**
Vorrichtung zur Breitband-Höchstfrequenz-Erkennung
Device for detecting broadband microwave frequencies

(30) Priorité: 23.06.2006 FR 0605661
(43) Date de publication de la demande: 26.12.2007
(73) Titulaire: Thales, 75008 Paris (FR)
(72) Inventeur: Mallet-Guy, Benoît, 75015, PARIS (FR); Dueme, Philippe, 91400, ORSAY (FR)
(74) Mandataire: Lucas, Laurent Jacques

(56) Documents cités:
- EP-A- 1 388 935
- FR-A- 2 882 204
- NAZOA-RUIZ N ET AL: "A logarithmic distributed amplifier" IEEE MTT-S INTERNATIONAL MICROWAVE SYMPOSIUM DIGES, 8 mai 1990 (1990-05-08), pages 753-756, XP010004493

## Description

La présente invention concerne un module de détection hyperfréquence. Elle concerne également un dispositif de détection hyperfréquence large bande composé d'un ou plusieurs modules de détection. Elle s'applique notamment pour la fabrication de détecteurs en circuits monolithiques hyperfréquence.

Un détecteur de niveau de puissance est utilisé afin de connaître de manière instantanée le niveau de puissance d'un signal hyperfréquence reçu. Les principales caractéristiques recherchées pour un détecteur de niveau de puissance large bande sont notamment les suivantes : il fonctionne sur une large bande de fréquences, il est capable de mesurer un signal sur une grande dynamique de niveaux de puissance et il dispose d'une bonne sensibilité pour de faibles niveaux de puissance du signal reçu.

A cette fin, une architecture connue consiste à cascader un circuit unitaire constitué de trois composants : une diode, un diviseur de puissance et un amplificateur large bande. Une telle architecture est notamment décrite dans le document : NAZOA-RUIZ N ET AL: "A logarithmic distributed amplifier" IEEE MTT-S INTERNATIONAL MICROWAVE SYMPOSIUM DIGES. Dans ce cas, l'amplificateur large bande utilisé peut être un circuit intégré hyperfréquence de type circuit intégré monolithique micro-ondes, ou MMIC, possédant une architecture dite distribuée. Le diviseur de puissance utilisé dans le circuit unitaire peut être une structure de type Wilkinson qui permet de traiter un signal à large bande de fréquences. Les inconvénients de ce circuit unitaire sont principalement liés à la présence du diviseur de type Wilkinson. Ce dernier introduit notamment un facteur de bruit élevé dans le signal traité. La sensibilité de la diode pour des amplitudes minimales est alors diminuée par les pertes dues au diviseur de type Wilkinson. Indépendamment du diviseur, le circuit unitaire possède l'inconvénient d'être constitué de trois composants distincts qu'il faut câbler entre eux et qui sont issus de technologies potentiellement différentes. De plus le diviseur utilisé pour traiter un signal hyperfréquence doit traiter une large bandé de fréquences. Un diviseur de type Wilkinson à large bande présente de nombreuses difficultés de fabrication et notamment des difficultés d'intégration sur un système électronique. Le circuit résultant est de taille importante et engendre des pertes internes considérables du fait des difficultés liées à l'adaptation de ce type de montage. Ceci induit un coût de production élevé lié à la complexité de la réalisation d'un tel circuit*

Le document EP-A-1 388935 décrit un amplificateur distribué comportant une résistance connectée sur la ligne de drains de l'amplificateur distribué.

Un but de l'invention est notamment de pallier les inconvénients précités. A cet effet, l'invention a pour objet un module de détection hyperfréquence comportant :
- un amplificateur distribué comportant N transistors à effet de champ connectés à une ligne de drains commune et à une ligne de grilles commune, l'amplificateur distribué ayant une entrée sur la ligne de grilles commune et une sortie sur la ligne de drains commune,
- un circuit de détection à base de semi-conducteur, le circuit de détection étant connecté à une extrémité de la ligne de grilles de l'amplificateur distribué.

Le circuit de détection peut être par exemple une diode Schottky, ou une diode PN.

Le module peut, par ailleurs, comporter un amplificateur distribué possédant une ligne de grilles commune avec ledit module de détection. Le module divise alors le signal, reçu sur une entrée de la ligne de grilles commune, en deux signaux l'un étant dirigé sur la sortie du module de détection et le second sur une sortie de l'amplificateur distribué. Le module peut aussi commuter le signal, reçu sur l'entrée de la ligne de grilles commune, soit vers la sortie du module de détection, soit sur une sortie de l'amplificateur distribué, la commutation étant effectuée par une commande en tension de polarisation des transistors du module de détection et de l'amplificateur distribué.

Le module peut également comporter un second module de détection comportant :
- un amplificateur distribué comportant N transistors à effet de champ connecté à une ligne de drains commune et à une ligne de grilles commune, l'amplificateur distribué ayant une entrée sur la ligne de grilles commune et une sortie sur la ligne de drains commune,
- un circuit de détection à base de semi-conducteur, le circuit de détection étant connecté à une extrémité de la ligne de grilles de l'amplificateur distribué,
et partageant la ligne de drains commune avec ledit module de détection. Le module commute le signal, reçu sur l'une des entrées, vers la sortie de la ligne de drains commune aux deux modules de détection, la commutation étant effectuée par une commande en tension de polarisation des transistors.
Une impédance peut être connectée en série au circuit de détection pour adapter ce circuit à l'impédance caractéristique de la ligne de grilles du module de détection.
L'invention a également pour objet un dispositif de détection caractérisé en ce qu'il comporte P modules de détection selon l'une quelconque des revendications précédentes, reliés en cascade, une sortie d'un module étant reliée à une entrée du module suivant.

L'invention a notamment pour avantage de couvrir une grande dynamique de niveaux de puissance tout en ayant une bonne sensibilité pour de faibles niveaux de puissance. De plus, le circuit détecteur selon l'invention possède l'avantage d'être modulaire, ce qui permet de l'utiliser dans de multiples configurations et applications. Le dispositif selon l'invention possède aussi l'avantage d'être simple à mettre en oeuvre ainsi qu'une certaine souplesse de réalisation. Il peut également avoir une taille réduite selon les modalités de fabrication employées.

D'autres caractéristiques et avantages de l'invention apparaîtront à l'aide de la description qui suit faite en regard des dessins annexés qui représentent :
- la figure 1 a : le schéma d'une diode ;
- la figure 1b : une tension délivrée aux bornes d'une diode en fonction de la puissance du courant qui la traverse ;
- la figure 2a : le schéma de principe d'un circuit de détection comprenant deux diodes ;
- la figure 2b : le fonctionnement en tension-puissance de deux diodes détectrices ;
- la figure 3 : une architecture d'un circuit détecteur de niveau large bande et grande dynamique selon l'art antérieur ;
- la figure 4 : un schéma de principe d'un amplificateur distribué ;
- la figure 5 : un schéma d'un circuit détecteur actif large bande selon l'invention ;
- les figure 6 et 7 : des variantes de réalisations possibles du détecteur selon l'invention.

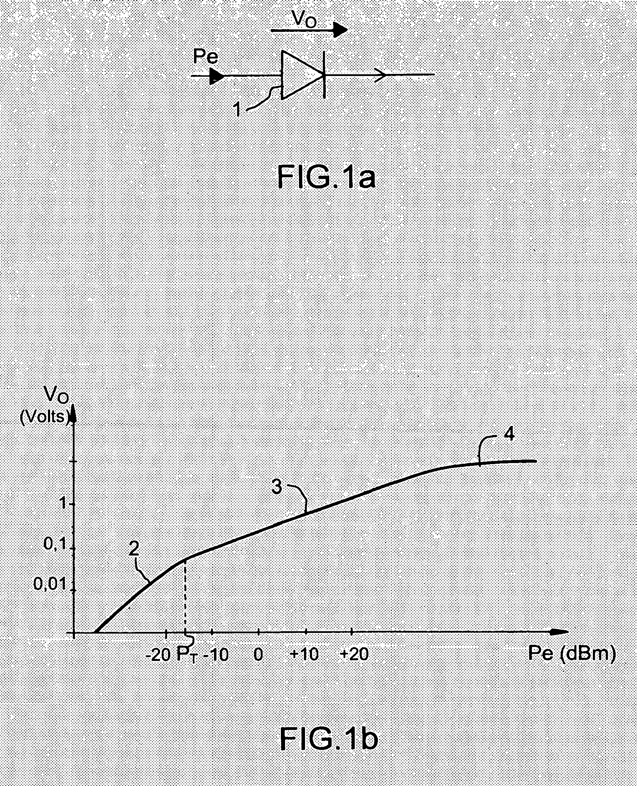

La figure 1a représente de manière schématique un détecteur à base de semi-conducteur 1 utilisé dans le cadre de l'invention afin de détecter la puissance du signal reçu. Ce détecteur peut être par exemple une diode PN ou une diode Schottky. La figure 1b représente la caractéristique tension-puissance de la diode 1. Cette diode 1 est donc utilisée afin de détecter la puissance électrique Pₑ d'un signal qui la traverse. Une des caractéristiques de la diode 1 est de délivrer à ses bornes une tension continue V₀ dont l'amplitude est une fonction quadratique 2 du niveau de puissance Pₑ qui la traverse. La zone de fonctionnement en détection 2 de la diode 1 se situe pour des puissances inférieures à une puissance P_{T}. Au-delà de cette puissance, la diode 1 passe à un régime 3 linéaire pendant lequel ses capacités de détection ne peuvent être utilisées, puis lorsque la puissance reçue Pₑ augmente encore, la diode 1 passe à un état de saturation 4.

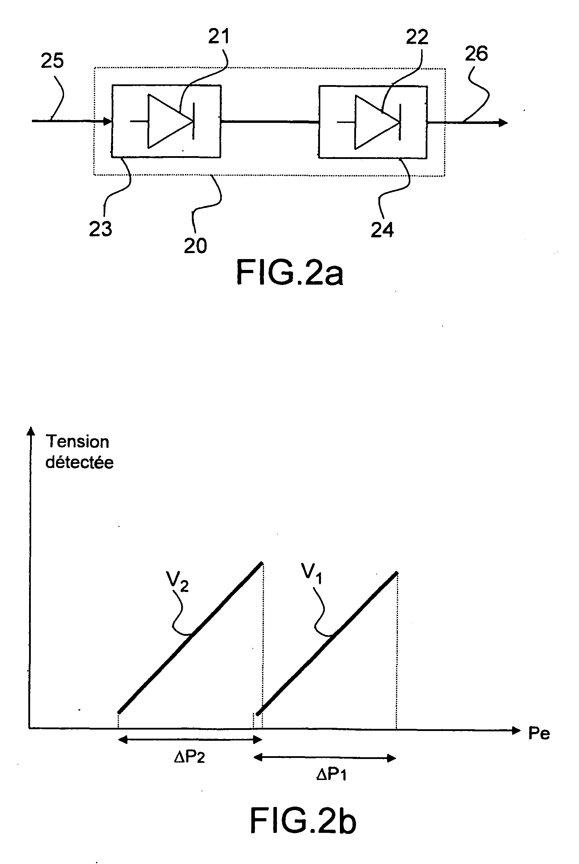

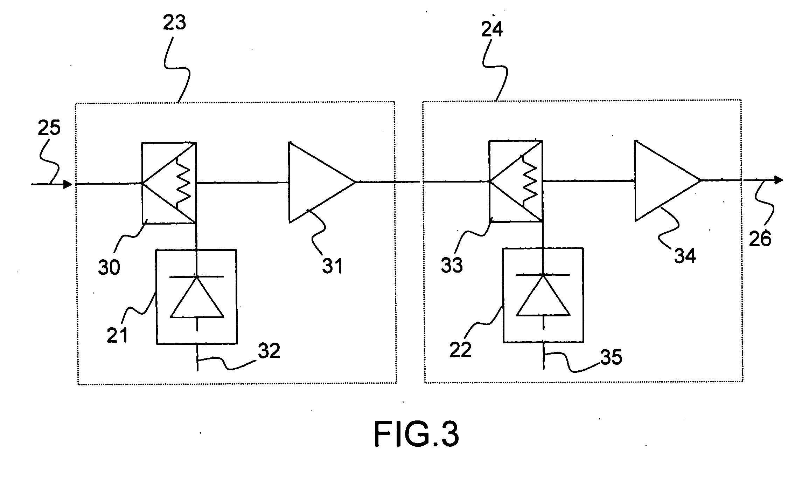

La figure 2a représente le schéma de principe d'un système de détection 20 utilisant plusieurs circuits de détection. Ce système 20 est par exemple composé de deux circuits 23, 24 comportant chacun une diode détectrice 21, 22 par exemple du type de la diode présentée figure 1a. Ces deux circuits 23, 24 sont cascadés, le signal hyperfréquence attaquant le circuit 23 par une entrée 25. La diode 21 détecte une tension V₁ puis le signal sort du circuit 23 pour entrer dans le circuit 24 où la diode 22 détecte une tension V₂. Le signal sort du circuit de détection 20 en un point de sortie 26. L'avantage d'utiliser en série au moins deux circuits 23, 24, comportant chacun une diode détectrice 21, 22, est de pouvoir traiter une plus large gamme de puissances, à condition d'amplifier le signal d'un circuit à l'autre comme cela sera décrit relativement à la figure 3.

La figure 2b présente le fonctionnement de la détection en tension-puissance de plusieurs diodes reliées en série. Le principe de la détection à l'aide d'une diode est d'utiliser sa zone de détection 2 présentée sur le schéma 1b afin de détecter une tension à ses bornes fonction de la puissance Pₑ du signal reçu. Cette zone de détection 2 correspond à une plage de puissances définie dont les valeurs dépendent des caractéristiques de la diode utilisée. Afin d'élargir la gamme de puissances sur laquelle la détection est effectuée, deux diodes 21 et 22, comme celle décrite sur le schéma 2a, peuvent par exemple être utilisées. Le circuit 23 reçoit en entrée un signal hyperfréquence de puissance Pₑ. La diode 21 détecte une tension V₁ pour des puissances Pₑ comprises dans une plage ΔP₁. Ensuite le signal sortant du circuit 23 est amplifié. Il entre alors dans le circuit 24 dans lequel la diode 22 détecte une tension V₂ pour des puissances Pₑ, comprises dans une plage ΔP₂, globalement plus faibles. L'amplification du signal permet à la puissance reçue par le circuit 24 d'être dans la plage de puissance correspondant à la zone de détection 2 de la diode 22. Le fait d'amplifier le signal permet donc d'utiliser les diodes de manière à ce que leurs zones de détection 2 se complètent afin de couvrir une gamme de puissances reçues Pₑ suffisamment large.

La figure 3 présente un exemple de circuit détecteur de niveaux de puissance large bande selon l'art antérieur. Afin de mesurer le signal sur une grande dynamique de niveaux de puissance et sur une large bande de fréquence, une architecture fréquemment utilisée consiste à cascader un circuit unitaire 23 comme décrit sur la figure 2a. Ce circuit unitaire 23 peut par exemple être constitué de trois composants : une diode détectrice 21 comme celle décrite par les figures 1 a et 1 b par exemple, un diviseur de puissance 30, et un amplificateur large bande 31. L'amplificateur large bande 31 peut être par exemple un circuit intégré hyperfréquence possédant une architecture distribuée.
Un signal hyperfréquence entre en un point d'accès 25 du premier des circuits unitaires 23, la figure représentant pour l'exemple deux circuits unitaires 23, 24. La puissance du signal reçu est ensuite divisée par le diviseur de puissance 30. Une partie de la puissance part dans la diode détectrice 21 qui consomme cette puissance et fournit en sortie 32 une tension détectée V₁. La seconde partie du signal entre dans l'amplificateur large bande 31 afin d'être amplifiée. Ce premier circuit unitaire 23 permet par exemple de détecter des niveaux de signal de forte puissance comme décrit sur la figure 2b. Le signal sortant de l'amplificateur 31 attaque l'entrée du second circuit unitaire 24. Il passe tout d'abord par un diviseur de puissance 33 qui dirige par exemple une première moitié de la puissance du signal vers une diode détectrice 22 et une seconde moitié vers un amplificateur large bande 34. L'amplificateur large bande 34 ré-amplifie le signal avant de le délivrer soit vers la sortie 26 du circuit soit vers l'entrée d'un autre circuit unitaire non représenté afin de détecter un troisième niveau de puissance. La diode 22 délivre à ses bornes une tension V₂ en fonction de la puissance entrant dans celle-ci comme décrit sur le schéma 2b. Le second circuit 24 est donc utilisé afin de détecter un niveau de puissance du signal plus faible que le premier niveau de puissance détecté par le premier circuit unitaire 23. En sorties 32, 35 de chaque diode 21, 22 sont connectés des circuits électroniques connus par ailleurs et non représentés effectuant une mesure de la tension aux bornes de la diode.
Un tel circuit présente de nombreux inconvénients et parmi ceux-ci, des difficultés de fabrication et d'intégration dans un système électronique. Il en résulte une taille importante des systèmes ainsi fabriqués et donc un coût élevé. La taille de ces systèmes engendre également des pertes internes importantes, ce qui réduit la sensibilité du circuit de détection.

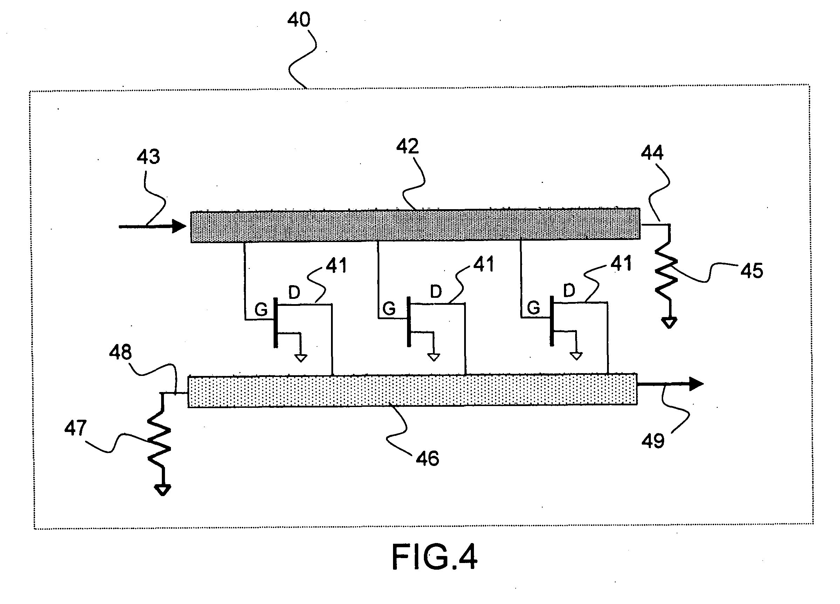

La figure 4 représente un schéma de principe d'un amplificateur distribué 40 utilisé dans un détecteur selon l'art antérieur. Cet amplificateur distribué 40 comprend N cellules amplificatrices montées en parallèle, à base d'un ou plusieurs transistors à effet de champ. Dans l'exemple de la figure 4, chaque cellule amplificatrice comporte un transistor 41. La grille d'un transistor est reliée à une ligne de grilles commune 42 qui s'étend d'un point d'entrée du montage 43 à un point d'accès 44 sur lequel est connecté une résistance 45 reliée à un potentiel de référence. Le drain du transistor est relié à une ligne de drains commune 46 qui s'étend entre une résistance 47, montée sur un accès 48 de la ligne de drains 46 et reliée à un potentiel de référence, et un point de sortie 49 du montage. La source du transistor est reliée au potentiel de référence. Par la suite le potentiel de référence sera assimilé au zéro électrique ou à la masse mécanique.
Les lignes de grilles 42 et de drains 46 sont des lignes composées essentiellement des capacités internes aux transistors 41 et d'inductances éventuellement liées par des mutuelles inductances. Ces inductances ajustée sont notamment prévues pour adapter la ligne à une impédance caractéristique par exemple de 50 Ohms. Afin d'adapter la ligne, la résistance 45 formant une charge annexe est ainsi prévue à 50 Ohms.
L'entrée de la ligne de grilles commune 42 forme l'entrée 43 de l'amplificateur distribué 40. L'autre extrémité 44 de la ligne de grilles est chargée sur une résistance terminale ou charge annexe 45 dont la valeur de résistance est sensiblement égale à l'impédance caractéristique de la ligne de grilles commune 42.
Dans le cas d'une réalisation suivant la technologie MMIC, les connexions des charges annexes se font généralement sur la puce et les accès 44, 48 ne sont pas disponibles.
Comme sur la ligne de grilles 42, l'une des extrémités de la ligne de drains commune 46 est chargée sur une résistance terminale 47 dont la valeur de résistance est sensiblement égale à l'impédance caractéristique de la ligne de drains commune 46, tandis que l'autre extrémité de la ligne de drains commune 46 définit la sortie 49 de l'amplificateur distribué.
Un circuit de polarisation non représenté sur la figure 4 applique une tension de polarisation continue sur la ligne de grilles commune 42.
Le fonctionnement d'un amplificateur distribué du type de celui illustré sur la figure 4 est le suivant. Un signal hyperfréquence reçu en entrée 43 se propage sur la ligne de grilles commune 42 pour être absorbé par la charge annexe 45. Sur chaque grille de transistors 41 passe donc un signal, se propageant de l'entrée 43 vers la charge annexe 45. Ce signal se propage à travers les transistors 41 vers la sortie 49, l'autre extrémité 48 de la ligne de drains 46 étant chargée par son impédance caractéristique. Ce signal hyperfréquence étant amplifié par les transistors 41, l'amplification est à très large bande passante car elle commence depuis le continu jusqu'aux fréquences de coupure liées aux caractéristiques des transistors 41. Ces fréquences de coupure peuvent être très hautes, de plusieurs dizaines de GHz, à la centaine de GHz.

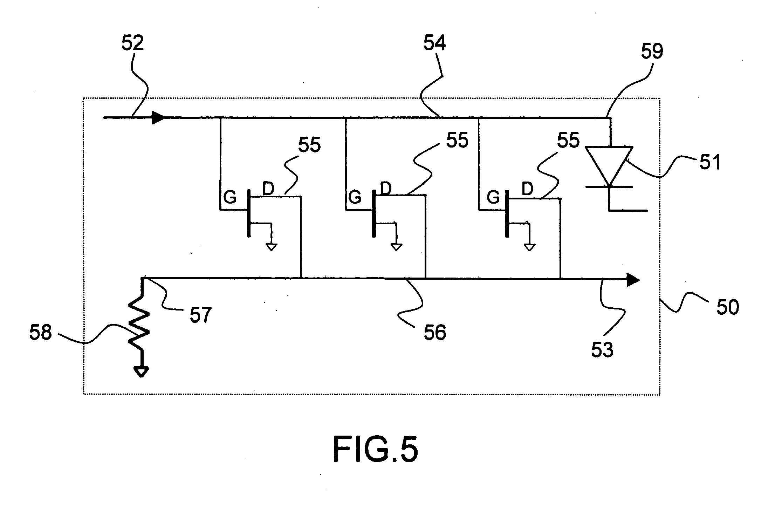

La figure 5 représente un module de base 50 utilisé dans un dispositif de détection selon l'invention. Ce module de base est un circuit intégrant un amplificateur distribué comme décrit sur la figue 4, la charge annexe 45 étant remplacée par un circuit de détection, par exemple une diode 51. Le circuit de base du détecteur selon l'invention est donc composé d'une entrée 52, d'une sortie amplifiée 53, de N transistors 55, d'une ligne de grilles commune 54, d'une ligne de drains commune 56, d'un accès 57 à la ligne de drains 56 sur lequel est connectée une charge annexe 58 et d'un accès 59 à la ligne de grilles 54. Cet accès 59 du circuit détecteur peut être laissé libre. Ceci permet donc de connecter le circuit de détection à base de semi-conducteur comme par exemple une diode 51, telle que décrite sur les figures 1a et 1b. Cette diode 51 permet ainsi à l'accès 59 de se comporter comme une sortie annexe non amplifiée sur laquelle le niveau de puissance du signal reçu est détecté par l'intermédiaire de la diode 51. Le niveau de la tension aux bornes de la diode, fonction du niveau de puissance du signal reçu, est ensuite mesuré par un circuit adapté non représenté sur la figure. Le niveau de puissance du signal mesuré est peu atténué par rapport au signal d'entrée. Une impédance est par exemple reliée en série à la diode 51 pour adapter la diode à l'impédance caractéristique de la ligne de grilles 54.
Avantageusement la diode 51 peut-être interne ou externe à un circuit intégré comportant l'amplificateur.
Le mode de réalisation de ce circuit est par exemple le même que celui de l'amplificateur distribué, c'est à dire une technologie MMIC.
Le module de détection 50 selon l'invention peut être utilisé en cascade à la place des circuits unitaires 23, 24 utilisés dans le montage décrit sur la figure 2a, en reliant par exemple la sortie 53 du premier module 23 à l'entrée 52 du second module 24. Ce qui permet de constituer un détecteur actif large bande pour une grande dynamique de niveaux de puissance, chacun des circuits 23, 24 détectant une gamme de puissance donnée.

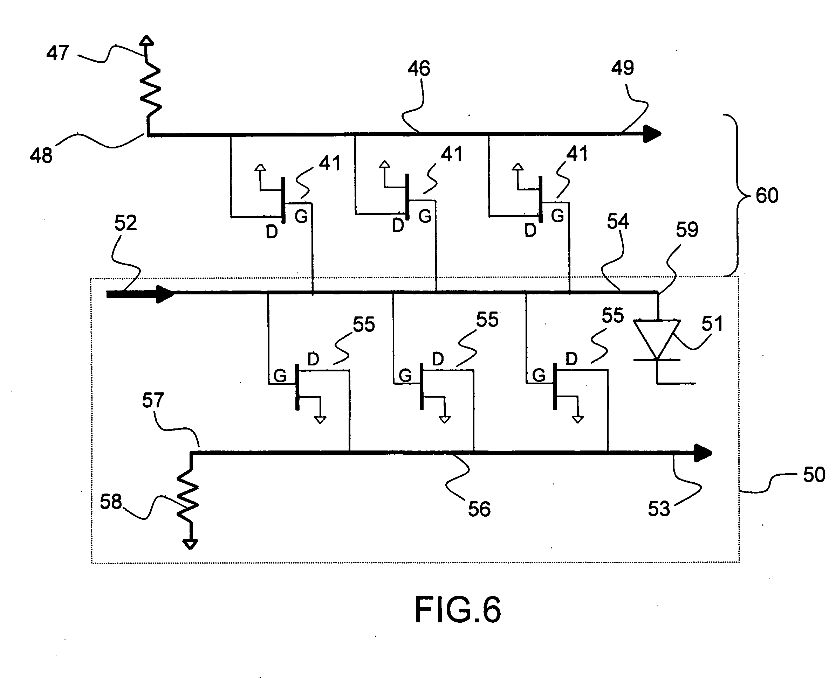

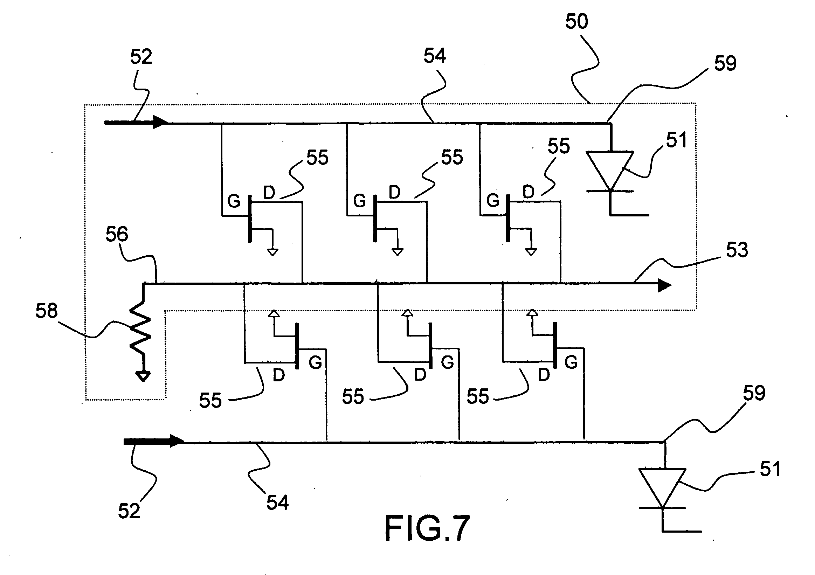

Les figures 6 et 7 représentent deux des variantes d'utilisation du module de détection selon l'invention.
Une première variante représentée sur la figure 6 est un circuit de détection ayant deux sorties amplifiées. Ce circuit est composé d'un module de détection 50 selon l'invention dont la ligne de grilles 54 est commune avec un amplificateur distribué 60 comme celui décrit au niveau de la figure 4. L'amplificateur distribué 60 possède donc une ligne de grilles 54 commune avec le module de détection 50. Les grilles des N transistors 41 de l'amplificateur distribué 60 sont donc connectées à la ligne de grilles commune 54 par leur grille, leur drain étant connecté à une ligne de drains 46 commune. La ligne de drains 46 présente à l'une de ses extrémités 48 une charge annexe 47 selon le principe de l'amplificateur distribué représenté figure 4. La seconde extrémité 49 de la ligne de drains 46 offre une seconde sortie au circuit de détection et d'amplification. Ce montage permet au circuit de fournir deux sorties différentes amplifiées 49 et 53 tout en conservant une sortie présentant un moyen de détection 51 du niveau de puissance du signal afin de pouvoir mesurer le niveau de puissance du signal entrant dans l'ensemble du circuit sur le point d'entrée 52. Ce circuit peut être utilisé par exemple comme un circuit détecteur possédant deux sorties, une partie du signal pouvant être dirigée vers la sortie 49 et la seconde partie du signal pouvant être dirigée vers la sortie 53. Dans une autre réalisation, ce circuit peut aussi être utilisé comme un circuit détecteur et commutateur. La commutation permet de diriger le signal reçu sur l'entrée 52 vers la sortie 53 ou la sortie 49 en jouant sur la polarisation des transistors. Par exemple, l'application d'une commande en tension de polarisation sur la première série de transistors 41 permet de rendre ces derniers passant et une autre commande en tension de polarisation appliquée sur l'autre série de transistors 55 permet de rendre ceux-ci non passant. Le signal reçu sur l'entrée 52 est alors dirigé sur la sortie 49 du circuit de détection.
La figure 7 présente une seconde variante : un circuit à deux entrées de détection. Ce circuit peut être réalisé en prenant un double module de détection 50 selon l'invention. Les deux modules ont une ligne de drains commune 56, le second module étant symétrique au premier module 50 par rapport à la ligne de drains 56 commune. Sur cette ligne de drains 56 commune aux deux modules sont connectés par leur drain un ensemble de N transistors 55. La grille de chacun des transistors 55 est connectée à une ligne de grilles commune 54. La ligne de grilles 54 possède une entrée 52 pour un signal hyperfréquence. Le signal reçu sur l'entrée 52 peut être détecté au niveau de l'accès 59 par une diode détectrice 51 telle que décrite par les figures 1a et 1b par exemple. L'ensemble du circuit possède alors deux entrées 52 permettant ainsi réaliser une double détection et de combiner les deux signaux reçus en un signal amplifié sortant sur l'accès 53.
Dans une autre réalisation, il est aussi possible de commuter l'un ou l'autre des signaux reçus vers la sortie 53 en jouant sur la polarisation des transistors. Chacun des signaux reçus étant détecté par les diodes 51 puis mesuré par un circuit adéquat non représenté sur la figure 7. Les transistors 55 du module 50 peuvent par exemple être commandés en tension de polarisation afin de les rendre passant, les transistors du second module étant alors commandés en tension de polarisation afin de les rendre non passant. Le signal reçu sur l'entrée 52 du premier module 50 est alors dirigé sur la sortie 53 du double module de détection.
Les deux figures 6, 7 illustrent deux exemples de la modularité du module de détection selon l'invention. Ce module de détection peut ainsi être utilisé ou adapté dans différents types de montages pour des utilisations variées.

Un module de détection de niveaux de puissance large bande 50 selon l'invention présente l'avantage de pouvoir se combiner par exemple avec d'autres circuits amplificateurs ou d'autres modules de détection de niveau large bande 50 selon de multiples configurations adaptables à chaque besoin spécifique en matière de détection du niveau de puissance d'un signal et de son amplification par exemple.
Un module de détection de niveaux de puissance large bande 50 peut être réalisé selon la technologie MMIC. La simplicité d'un tel module permet avantageusement de réaliser un circuit MMIC de taille réduite et de conception beaucoup plus simple qu'un circuit selon l'art antérieur, d'où un gain de place et de coût de réalisation.
Un autre avantage du module de détection 50 est sa grande souplesse de mise en oeuvre. En effet, il est possible de sortir la diode 51 du circuit 50 en laissant ainsi libre son point d'accès 59 afin de connecter de manière externe une diode adaptée.
Un circuit détecteur actif large bande pour une grande dynamique de fréquence peut être obtenu en cascadant le module de détection 50. Ce montage permet avantageusement d'obtenir une bonne sensibilité de détection pour différents niveaux de puissance du signal reçu, et notamment pour de faibles niveaux de puissance.

## Revendications

1. Module de détection hyperfréquence comportant un circuit de détection à base de semi-conducteur (51), un amplificateur distribué comportant N transistors à effet de champ (55) connecté à une ligne de drains commune (56) et à une ligne de grilles commune (54), l'amplificateur distribué ayant une entrée (52) sur la ligne de grilles commune (54) et une sortie (53) sur la ligne de drains commune (56), le circuit de détection (51) étant connecté à une extrémité (59) de la ligne de grilles (54) de l'amplificateur distribué.

2. Module selon la revendication 1, **caractérisé en ce que** le circuit de détection (51) est une diode.

3. Module selon la revendication 2, **caractérisé en ce que** la diode (51) est une diode Schottky.

4. Module selon la revendication 2, **caractérisé en ce que** la diode (51) est une diode PN.

5. Module selon les revendications 1 à 4, **caractérisé en ce qu'**il comporte un amplificateur distribué (60) possédant une ligne de grilles commune (54) avec ledit module de détection (50).

6. Module selon la revendication 5, **caractérisé en ce qu'**il divise le signal, reçu sur une entrée (52) de la ligne de grilles commune (54), en deux signaux l'un étant dirigé sur la sortie (53) du module de détection (50) et le second sur une sortie (49) de l'amplificateur distribué (60).

7. Module selon la revendication 5, **caractérisé en ce qu'**il commute le signal, reçu sur l'entrée (52) de la ligne de grilles commune (54), soit vers la sortie (53) du module de détection (50), soit sur une sortie (49) de l'amplificateur distribué (60), la commutation étant effectuée par une commande en tension de polarisation des transistors (41, 55) du module de détection (50) et de l'amplificateur distribué (60).

8. Module selon les revendications 1 à 4, **caractérisé en ce qu'**il comporte un second module de détection comportant :
• un amplificateur distribué comportant N transistors à effet de champ (55) connecté à une ligne de drains commune (56) et à une ligne de grilles commune (54), l'amplificateur distribué ayant une entrée (52) sur la ligne de grilles commune (54) et une sortie (53) sur la ligne de drains commune (56),
• un circuit de détection à base de semi-conducteur (51), le circuit de détection (51) étant connecté à une extrémité (59) de la ligne de grilles (54) de l'amplificateur distribué,
et partageant la ligne de drains commune (56) avec ledit module de détection (50).

9. Module selon la revendication 8, **caractérisé en ce qu'**il commute le signal reçu sur l'une des entrées (52) vers la sortie (53) de la ligne de drains commune (56) aux deux modules de détection (50), la commutation étant effectuée par une commande en tension de polarisation des transistors (55).

10. Module selon l'une quelconque des revendications précédentes, **caractérisé en ce qu'**une impédance est connectée en série au circuit de détection (51) pour adapter ce circuit (51) à l'impédance caractéristique de la ligne de grilles (54) du module de détection (50).

11. Dispositif de détection **caractérisé en ce qu'**il comporte P modules de détection selon l'une quelconque des revendications précédentes, reliés en cascade, une sortie (49, 53) d'un module étant reliée à une entrée (52) du module suivant.

## Patentansprüche

1. Höchstfrequenzerkennungsmodul, das Folgendes umfasst: eine halbleiterbasierte Erkennungsschaltung (51), einen verteilten Verstärker mit N Feldeffekttransistoren (55), die an eine gemeinsame Drain-Leitung (56) und eine gemeinsame Gate-Leitung (54) angeschlossen sind, wobei der verteilte Verstärker einen Eingang (52) auf der gemeinsamen Gate-Leitung (54) und einen Ausgang (53) auf der gemeinsamen Drain-Leitung (56) aufweist, wobei die Erkennungsschaltung (51) mit einem Ende (59) der Gate-Leitung (54) des verteilten Verstärkers verbunden ist.

2. Modul nach Anspruch 1, **dadurch gekennzeichnet, dass** die Erkennungsschaltung (51) eine Diode ist.

3. Modul nach Anspruch 2, **dadurch gekennzeichnet, dass** die Diode (51) eine Schottky-Diode ist.

4. Modul nach Anspruch 2, **dadurch gekennzeichnet, dass** die Diode (51) eine PN-Diode ist.

5. Modul nach einem der Ansprüche 1 bis 4, **dadurch gekennzeichnet, dass** es einen verteilten Verstärker (60) mit einer mit dem Erkennungsmodul (50) gemeinsamen Gate-Leitung (54) umfasst.

6. Modul nach Anspruch 5, **dadurch gekennzeichnet, dass** es das am Eingang (52) der gemeinsamen Gate-Leitung (54) empfangene Signal in zwei Signale unterteilt, von denen eines auf den Ausgang (53) des Erkennungsmoduls (50) und das zweite auf einen Ausgang (49) des verteilten Verstärkers (60) gerichtet ist.

7. Modul nach Anspruch 5, **dadurch gekennzeichnet, dass** es das am Eingang (52) der gemeinsamen Gate-Leitung (54) empfangene Signal entweder auf den Ausgang (53) des Erkennungsmoduls (50) oder auf einen Ausgang (49) des verteilten Verstärkers (60) schaltet, wobei die Schaltung über einen Vorspannungsbefehl der Transistoren (41, 55) des Erkennungsmoduls (50) und des verteilten Verstärkers (60) erfolgt.

8. Modul nach einem der Ansprüche 1 bis 4, **dadurch gekennzeichnet, dass** es ein zweites Erkennungsmodul umfasst, das Folgendes umfasst:
• einen verteilten Verstärker mit N Feldeffekttransistoren (55), die an eine gemeinsame Drain-Leitung (56) und eine gemeinsame Gate-Leitung (54) angeschlossen sind, wobei der verteilte Verstärker einen Eingang (52) auf der gemeinsamen Gate-Leitung (54) und einen Ausgang (53) auf der gemeinsamen Drain-Leitung (56) aufweist,
• eine halbleiterbasierte Erkennungsschaltung (51), wobei die Erkennungsschaltung (51) mit einem Ende (59) der Gate-Leitung (54) des verteilten Verstärkers verbunden ist,
und gemeinsames Nutzen der gemeinsamen Drain-Leitung (56) mit dem Erkennungsmodul (50).

9. Modul nach Anspruch 8, **dadurch gekennzeichnet, dass** es das auf einem der Eingänge (52) empfangene Signal auf den Ausgang (53) der den beiden Erkennungsmodulen (50) gemeinsamen Drain-Leitung (56) schaltet, wobei die Schaltung über einen Vorspannungsbefehl der Transistoren (55) erfolgt.

10. Modul nach einem der vorherigen Ansprüche, **dadurch gekennzeichnet, dass** eine Impedanz in Serie mit der Erkennungsschaltung (51) geschaltet ist, um die Schaltung (51) an die Impedanz anzupassen, die für die Gate-Leitung (54) des Erkennungsmoduls (50) charakteristisch ist.

11. Erkennungsvorrichtung, **dadurch gekennzeichnet, dass** sie in Kaskade geschaltete P Erkennungsmodule nach einem der vorherigen Ansprüche umfasst, wobei ein Ausgang (49, 53) eines Moduls mit einem Eingang (52) des folgenden Moduls verbunden ist.

## Claims

1. A hyper-frequency detection module comprising a semiconductor-based detection circuit (51), a distributed amplifier comprising N field-effect transistors (55) connected to a common drain line (56) and to a common gate line (54), said distributed amplifier having an input (52) on said common gate line (54) and an output (53) on said common drain line (56), **characterised in that** said detection circuit (51) is connected to one end (59) of said gate line (54) of said distributed amplifier.

2. The module according to claim 1, **characterised in that** said detection circuit (51) is a diode.

3. The module according to claim 2, **characterised in that** said diode (51) is a Schottky diode.

4. The module according to claim 2, **characterised in that** said diode (51) is a PN diode.

5. The module according to any one of claims 1 to 4, **characterised in that** it comprises a distributed amplifier (60) having a gate line (54) that it shares with said detection module (50).

6. The module according to claim 5, **characterised in that** it divides the signal received on an input (52) of said common gate line (54) into two signals, one being directed to the output (53) of said detection module (50) and the second to an output (49) of said distributed amplifier (60).

7. The module according to claim 5, **characterised in that** it switches the signal received on the input (52) of said common gate line (54) either to said output (53) of said detection module (50) or to an output (49) of said distributed amplifier (60), the switching being carried out by a bias voltage command of the transistors (41, 55) of said detection module (50) and of said distributed amplifier (60).

8. The module according to any one of claims 1 to 4, **characterised in that** it comprises a second detection module comprising:
• a distributed amplifier comprising N field-effect transistors (55) connected to a common drain line (56) and to a common gate line (54), said distributed amplifier having an input (52) on said common gate line (54) and an output (53) on said common drain line (56),
• a semiconductor-based detection circuit (51), said detection circuit (51) being connected to one end (59) of said gate line (54) of said distributed amplifier,
and sharing said common drain line (56) with said detection module (50).

9. The module according to claim 8, **characterised in that** it switches the signal received on one of the inputs (52) to the output (53) of said drain line (56) that is shared by the two detection modules (50), the switching being carried out by a bias voltage command of the transistors (55).

10. The module according to any one of the preceding claims, **characterised in that** an impedance is connected in series to the detection circuit (51) in order to adapt said circuit (51) to the characteristic impedance of the gate line (54) of said detection module (50).

11. A detection device, **characterised in that** it comprises P detection modules according to any one of the preceding claims, connected in a cascade like manner, an output (49, 53) of a module being connected to an input (52) of the next module.
